# EUROPEAN PATENT APPLICATION

(11) **EP 3 859 413 A1**
(43) Date of publication of application: **04.08.2021**
(21) Application number: 21154002.6
(22) Date of filing: 28.01.2021
(51) Int. Cl.: G02B 6/12, G02B 6/13, G02B 6/136, H01L 21/02, H01L 21/203, C23C 14/34, C23C 14/35, G02B 6/132

(54) **PHOTONIC INTEGRATED CIRCUIT WITH SPUTTERED SEMICONDUCTOR MATERIAL**

(30) Priority: 30.01.2020 US 202016777318
(71) Applicant: Viavi Solutions Inc., San Jose, CA 95002 (US)
(72) Inventor: HOUCK, William D., Santa Rosa, CA California 95404 (US); BILGER, Markus, Santa Rosa, CA California 95405 (US)
(74) Representative: Murgitroyd & Company

(57) **Abstract**

A sputtering system may inject hydrogen and a sputtering gas into a chamber of the sputtering system, which may cause at least one layer of a hydrogenated semiconductor material, such as hydrogenated silicon (Si:H), to be sputtered onto a substrate disposed in the chamber until the at least one layer has a thickness that satisfies a threshold. In some implementations, the hydrogen and the sputtering gas may be injected into the chamber of the sputtering system while a temperature in the chamber is in a range from 145 degrees Celsius to 165 degrees Celsius. Accordingly, in some implementations, the sputtered layer of the hydrogenated semiconductor material may have one or more optical properties that satisfy a threshold to enable operation in a 9xx nanometer wavelength regime and at larger wavelengths.

## Description

### BACKGROUND

Photonics technology includes sources of light such as lasers and light-emitting diodes, waveguides such as fiber optics to guide light, and various opto-electronic devices that encode digital information into optical signals and convert optical signals to electrical signals. These components are typically discrete and physically separate from one another, and need to be mated together by various coupling mechanisms to create a complete optical circuit. In contrast, integrated photonics is an emerging branch of photonics in which waveguides and other photonic devices are fabricated as an integrated structure on a substrate surface. For example, a photonic integrated circuit (PIC) may use semiconductor-grade materials (e.g., silicon, indium phosphide, dielectrics such as silicon dioxide or silicon nitride, and/or the like) as a platform to integrate active and passive photonic circuits with electronic components on a single chip. As a result of integration, complex photonic circuits can process and transmit light (e.g., photons) in similar ways to how electronic integrated circuits process and transmit electrons.

### SUMMARY

According to some implementations, a method for fabricating a photonic integrated circuit may include: injecting hydrogen and a sputtering gas into a chamber of a sputtering system; and sputtering, based on injecting the hydrogen and the sputtering gas into the chamber, at least one layer of a hydrogenated semiconductor material onto a substrate disposed in the chamber of the sputtering system until the at least one layer has a thickness that satisfies a threshold

The at least one layer of the hydrogenated semiconductor material may include an amorphous hydrogenated silicon (a-Si:H) material.

The at least one layer of the hydrogenated semiconductor material may be sputtered onto the substrate while a temperature in the chamber of the sputtering system is in a range from 145 degrees Celsius to 165 degrees Celsius.

The at least one layer of the hydrogenated semiconductor material may be sputtered onto the substrate using reactive magnetron sputtering.

The method may further comprise: etching a surface of the at least one layer of the hydrogenated semiconductor material using reactive ion etching to form a waveguide structure. The method may further comprise: depositing, on the etched surface of the at least one layer of the hydrogenated semiconductor material, an additional material layer to form a confinement layer for the waveguide structure.

The at least one sputtered layer of the hydrogenated semiconductor material may have a first refractive index, and the method may further comprise: depositing, on the at least one sputtered layer of the hydrogenated semiconductor material, an additional layer of a material having a second refractive index that is less than the first refractive index, to form an optical filter structure.

The at least one sputtered layer of the hydrogenated semiconductor material may have one or more optical properties that satisfy a threshold at wavelengths in a range from 800 nanometers to 1100 nanometers.

The one or more optical properties of the at least one sputtered layer of the hydrogenated semiconductor material may satisfy the threshold at wavelengths larger than 1100 nanometers.

The one or more optical properties may include at least one of a transmissivity, an absorption, or a refractive index.

According to some implementations, a method for fabricating a photonic integrated circuit may include: injecting hydrogen and a sputtering gas into a chamber of a sputtering system while a temperature in the chamber is in a range from 145 degrees Celsius to 165 degrees Celsius; and sputtering a layer of hydrogenated silicon (Si:H) onto a substrate disposed in the chamber based on injecting the hydrogen and the sputtering gas into the chamber, wherein the sputtered layer of the Si:H has one or more optical properties that satisfy a threshold in a 9xx nanometer wavelength regime.

The 9xx nanometer wavelength regime may include wavelengths in a range from 800 nanometers to 1100 nanometers.

The layer of the Si:H may be sputtered onto the substrate until a thickness of the sputtered layer of the Si:H satisfies a threshold.

The one or more optical properties of the sputtered layer of the Si:H may satisfy the threshold in a 1550 nanometer wavelength regime.

The layer of the Si:H may be sputtered onto the substrate using reactive magnetron sputtering.

The sputtered layer of the Si:H may have one or more of a higher transmissivity, a lower absorption, or a higher refractive index in the 9xx nanometer wavelength regime relative to monocrystalline silicon.

The sputtered layer of the Si:H may have one or more of a higher transmissivity, a lower absorption, or a higher refractive index in the 9xx nanometer wavelength regime relative to Si:H deposited by plasma enhanced chemical vapor deposition.

According to some implementations, a method for fabricating a photonic integrated circuit may include: injecting, by a sputtering system, hydrogen and a sputtering gas into a chamber that includes a substrate and at least one target formed from a semiconductor material, wherein injecting the hydrogen and the sputtering gas into the chamber causes a hydrogenated layer of the semiconductor material to be sputtered onto the substrate using reactive magnetron sputtering until the hydrogenated layer of the semiconductor material has a thickness that satisfies a threshold; and patterning a surface of the hydrogenated layer of the semiconductor material using reactive ion etching to form a planar waveguide structure.

The planar waveguide structure may have an air cladding.

The method may further comprise: depositing, on the etched surface of the hydrogenated layer of the semiconductor material, an additional layer to form a confinement layer for the planar waveguide structure.

### BRIEF DESCRIPTION OF THE DRAWINGS

Fig. 1 is a diagram of an example sputter deposition system for fabricating one or more example implementations described herein.
Figs. 2A-2D are plots of one or more examples of optical characteristics for layers formed from a hydrogenated semiconductor material.
Figs. 3A-3D are diagrams of one or more example implementations described herein.
Figs. 4-6 are flowcharts of example processes for fabricating a photonic integrated circuit with one or more layers formed from a sputtered semiconductor material.

### DETAILED DESCRIPTION

The following detailed description of example implementations refers to the accompanying drawings. The same reference numbers in different drawings may identify the same or similar elements.

Planar waveguides and active nonlinear devices may be used as part of a class of devices known as silicon photonics. Silicon photonics is an evolving technology in which data is transferred photonically using silicon as an optical medium, which may enable a new class of computation by providing fully integrated photonic circuitry. However, one challenge in silicon photonics is merging photonic circuitry with electronic circuitry, which generally depends on the compatibility of processes used for each technology. For example, silicon (Si) waveguides are typically made from mono-crystalline Si built upon highly engineered (and therefore expensive) silicon on insulator (SOI) substrates, or from amorphous hydrogenated silicon (a-Si:H) deposited by plasma-enhanced chemical vapor deposition (PECVD) processes at high temperatures (e.g., from 200° to 400° Celsius). These temperatures may limit the ability to integrate technologies at any point in a complementary metal-oxide-semiconductor (CMOS) fabrication flow, and may create difficulties in achieving accurate and uniform thickness with exact optical properties. Furthermore, another limitation of approaches that rely upon mono-crystalline Si or a-Si:H deposited via PECVD processes is that usable wavelengths are confined to ranges that are not largely absorbed by Si, such as 1550 nm, and associated with complex and expensive lasers.

Some implementations described herein relate to photonic integrated circuits (PICs) (e.g., planar waveguides, active nonlinear devices, optical filters, and/or the like) that include one or more layers formed from a sputtered semiconductor material, and to processes to fabricate a PIC that includes one or more layers formed from a sputtered semiconductor material. In this way, the sputtered semiconductor material may offer tailored optical properties and thicknesses across large-area substrates at a high uniformity. For example, in some implementations, the sputtered semiconductor material may be a hydrogenated semiconductor material, such as hydrogenated silicon (Si:H), amorphous Si:H (a-Si:H), and/or the like, which generally has a higher transmissivity, a lower absorption coefficient, and a higher refractive index relative to conventional monocrystalline silicon. Accordingly, using the hydrogenated semiconductor material may enable a wider wavelength window of operation (e.g., the optical properties of sputtered Si:H or a-Si:H may enable operation in a 9xx nanometer wavelength regime, such as the near-infrared wavelength range from 800 to 1100 nanometers, which may also be enabling at longer wavelengths, such as 1550 nanometers and/or the like). Additionally, the sputtered semiconductor material may enable integration with other optical films with design advantages that may not be possible or feasible using PECVD or other reactive deposition technologies. For example, using a sputtered semiconductor material for planar waveguides, active nonlinear devices, and/or the like, such as those used for silicon photonics, may provide better uniformity over a larger area, lower deposition temperature leading to better integration with other processes including CMOS, tailored optical properties, a larger transmission window, a lower potential cost, and/or the like. Furthermore, the hydrogenated semiconductor material may have a higher third-order nonlinear susceptibility relative to monocrystalline silicon, and this tensor parameter affects the optical Kerr and Pockels effects (e.g., a change in refractive index due to light intensity, electrical bias, and/or the like) and two-photon absorption, which are important factors to be considered when designing silicon photonics structures and in-plane optical switching.

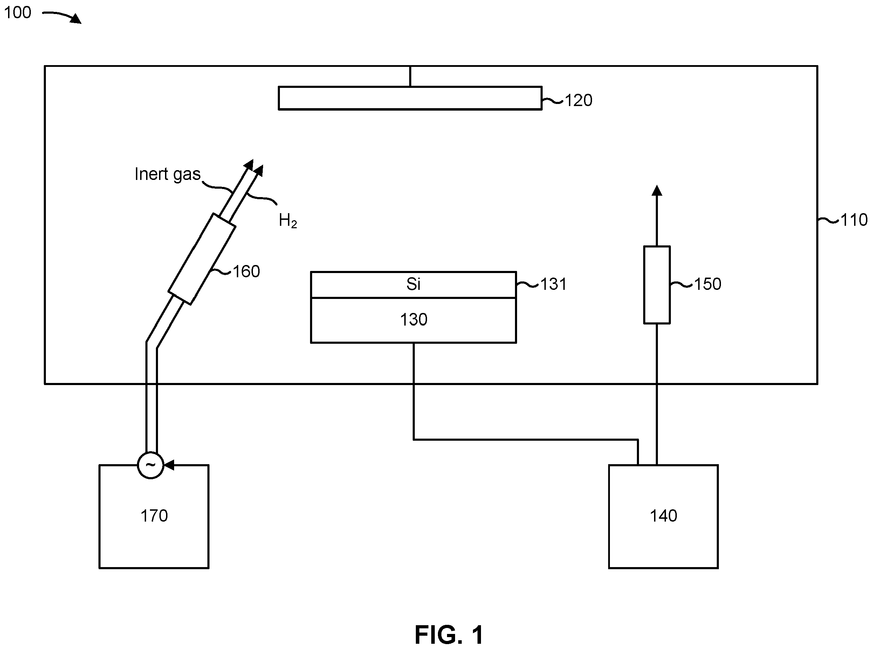

Fig. 1 is a diagram of an example sputter deposition system 100 for fabricating one or more example implementations described herein.

As shown in Fig. 1, the sputter deposition system 100 may include a vacuum chamber 110, a substrate 120, a cathode 130, a target 131, a cathode power supply 140, an anode 150, a plasma activation source (PAS) 160, and a PAS power supply 170. In some implementations, the target 131 may include a semiconductor material, such as silicon. Additionally, or alternatively, in some implementations, the semiconductor material may include a germanium material, a silicon-germanium material in a particular concentration selected based on optical characteristics of the particular concentration, and/or the like. In another example, an angle of the cathode 130 may be configured to cause a particular concentration of the semiconductor material to be sputtered onto the substrate 120. In some implementations, the PAS power supply 170 may be utilized to power the PAS 160 and may include a radio frequency (RF) power supply. The cathode power supply 140 may be utilized to power the cathode 130 and may include a pulsed direct current (DC) power supply. In some implementations, the sputter deposition system 100 may cause one or more layers to be sputtered onto the substrate 120 via a reactive magnetron sputtering process, a pulsed-magnetron sputtering process, and/or the like.

As shown in Fig. 1, the target 131 may be sputtered in the presence of hydrogen (H₂), as well as an inert gas (e.g., argon, an argon-helium mixture, and/or the like), to deposit a hydrogenated semiconductor material (e.g., hydrogenated silicon (Si:H)) as a layer on the substrate 120. The inert gas may be introduced into the chamber via the anode 150 and/or the PAS 160. Additionally, or alternatively, the walls of the vacuum chamber 110 may serve as the anode, and the inert gas may be introduced at a different location. Hydrogen may be introduced into the vacuum chamber 110 through the PAS 160, which serves to activate the hydrogen. Additionally, or alternatively, the cathode 130 may cause hydrogen activation, in which case the hydrogen may be introduced from another part of the vacuum chamber 110, or the anode 150 may cause hydrogen activation, in which case the anode 150 may introduce the hydrogen into the vacuum chamber 110. Additionally, or alternatively, the hydrogen may be injected from another direction, from a gas manifold within a threshold proximity of the cathode 130, and/or the like.

In some implementations, the hydrogen may take the form of hydrogen gas, a mixture of hydrogen gas and a noble gas (e.g., argon gas), and/or the like. The PAS 160 may be located within a threshold proximity of the cathode 130, allowing plasma from the PAS 160 and plasma from the cathode 130 to overlap. The use of the PAS 160 may allow the layer of the hydrogenated semiconductor material to be deposited at a relatively high deposition rate. For example, in some implementations, the layer of the hydrogenated semiconductor material may be deposited at a deposition rate of approximately 0.05 nanometers per second (nm/s) to approximately 2.0 nm/s, at a deposition rate of approximately 0.5 nm/s to approximately 1.2 nm/s, at a deposition rate of approximately 0.8 nm/s, and/or the like. Accordingly, using a sputtering process to deposit the layer of the hydrogenated semiconductor material may provide substantial precision in a thickness of the layer of the hydrogenated semiconductor material, such as at an accuracy of +/- 1%. Furthermore, introducing the hydrogen to hydrogenate the sputtered semiconductor material may result in the sputtered semiconductor material being deposited on the substrate 120 with an amorphous structure in which the semiconductor material includes some hydrogen atoms with compensating dangling bonds seated in interstitial regions. In this way, the sputtered hydrogenated semiconductor material may have a lower defect density and increased conductivity relative to an unhydrogenated semiconductor material, which may result in the sputtered hydrogenated semiconductor material having various optical properties that may significantly improve photoconductivity, enable doping, and/or the like.

Accordingly, in an example sputter deposition process, the substrate 120 is placed in the vacuum chamber 110 filled with the inert gas, which may be referred to herein as a "sputtering gas," at a low pressure. The target 131 formed from the semiconductor material to be sputtered is disposed near the substrate 120 and may be connected to a negative electrode, or to cathode 130. A positive electrode, or anode 150, may be disposed nearby within the vacuum chamber 110. A high negative voltage (e.g., between -100 and -1000 Volts) may be applied to the cathode 130, causing the sputtering gas to be ionized and causing a plasma discharge to form above the target 131. Positively charged sputtering gas ions may bombard the negatively charged target 131, which causes atoms of the target 131 to be thrown (sputtered) in space, fly towards the substrate 120, and adhere to the substrate 120. In a variety of sputter deposition process called reactive sputter deposition, a reactive gas, such as hydrogen, is further introduced into the vacuum chamber 110 to immediately enter into a chemical reaction with the sputtered atoms and/or the atoms that have already adhered to the substrate 120, forming a chemical compound film, such as a hydrogenated silicon (Si:H) film, an amorphous Si:H film, and/or the like. In general, as described above, the hydrogen may be introduced into the vacuum chamber 110 through the PAS 160, which serves to activate the hydrogen, as activated hydrogen is more chemically reactive. Accordingly, activating the hydrogen introduced into the vacuum chamber 110 is more likely to create silicon-hydrogen bonds that may contribute to the hydrogenated semiconductor material having certain optical properties, as described in more detail below.

In some implementations, in order to increase a deposition rate and/or lower an operating pressure in the vacuum chamber 110, the target 131 may be magnetically enhanced. When the sputtering process uses a magnetically-enhanced target 131 and a reactive gas to chemically react with sputtered atoms, the sputtering process may be referred to as reactive magnetron sputtering. For example, in a planar magnetron, the cathode 130 may include an array of permanent magnets that are arranged in a closed loop and mounted in a fixed position in relation to the target 131. Accordingly, a magnetic field causes the electrons to travel in a closed loop, commonly referred to as a "race track," which establishes a path or region along which sputtering or erosion of the material used to form the target 131 takes place. In a magnetron cathode 130, a magnetic field confines a glow discharge plasma and increases a path length of the electrons moving under the influence of the electric field, which results in an increase in the gas atom-electron collision probability, thereby leading to a much higher sputtering rate than what would be obtained without the use of magnetic confinement. Furthermore, the sputtering process can be accomplished at a much lower gas pressure, which enables a temperature in the vacuum chamber 110 to be reduced, since pressure and temperature are directly proportional in a closed system where volume is held constant.

For example, in some implementations, the reactive magnetron sputtering process may be performed while a temperature in the vacuum chamber 110 is in a range from 145° Celsius to 165° Celsius, from 150° Celsius to 160° Celsius, and/or the like. In this way, multiple planar layers of circuitry may be created because the temperature in the vacuum chamber 110 is below a level at which technologies such as ion implants, doping profiles, thin films, and/or the like may be damaged due to coefficients of thermal expansion or other temperature sensitivities. For example, fabricating a photonic integrated circuit (e.g., in silicon photonics) may generally be constrained according to a thermal process budget to realize necessary structures without exposing a layer, stack, doping profile, and/or the like to temperatures that may cause damage. In some cases, such as when monocrystalline silicon or Si:H are deposited via PECVD, fabrication steps that can be performed in process integration may be limited because the fabrication steps may need to be performed at high temperatures or using chemistry that would cause damage to layers and devices that have been created. Accordingly, when sputtering is used as a deposition process and Si:H is used as the semiconductor material, fabrication steps can be carried out at lower temperatures using a material with high-performance optical properties, which may enable a second planar layer of circuitry to be created on top of a first planar layer of circuitry. For example, as described in more detail elsewhere herein, an Si:H layer having a substantially uniform thickness may be created on a wafer, and a second photonic circuit may then be created on top of the uniform Si:H layer with the same planar design, which may be possible because the deposition is performed at a low temperature. In contrast, if the same deposition process were to be performed at a high temperature (e.g., 400° Celsius for Si:H deposited via PECVD), the higher temperature may destroy the underlying layer, which limits the possible fabrication steps to at most one planar layer of circuitry.

As indicated above, Fig. 1 is provided merely as one or more examples. Other examples may differ from what is described with regard to Fig. 1.

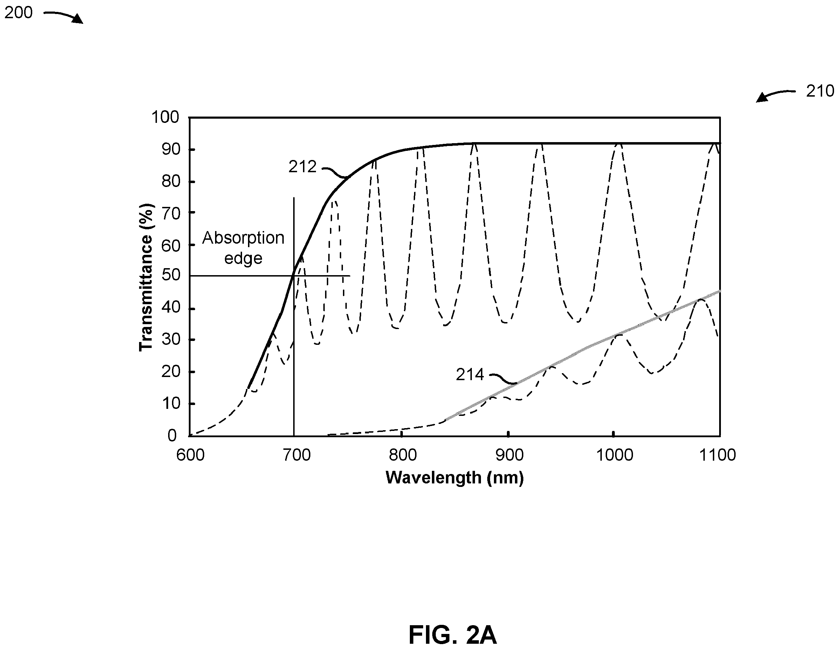

Figs. 2A-2D are plots of one or more examples 200 of optical characteristics for layers formed from a hydrogenated semiconductor material, such as sputtered Si:H, sputtered a-Si:H, and/or the like. As described herein, the optical characteristics of the hydrogenated semiconductor material may depend on hydrogen content in a vacuum chamber (and therefore a hydrogen flow rate in the vacuum chamber) when the sputtering process is performed. However, it will be appreciated that the optical characteristics of the hydrogenated semiconductor material may be influenced by other parameters, such as a flow rate of an inert gas, a PAS power level, a cathode power level, a deposition rate, a temperature, a pressure, and/or the like.

As shown in Fig. 2A, and by chart 210, a semiconductor material layer may have a significantly higher transmittance level over a wavelength range from approximately 800 nm to approximately 1100 nm when the semiconductor material layer is deposited via sputtering in the presence of hydrogen. For example, reference number 212 shows transmission spectra for a sputtered silicon layer deposited to a thickness of 1500 nm in the presence of hydrogen at a flow rate of 139 standard cubic centimeters per minute (sccm), and reference number 214 shows transmission spectra for a sputtered silicon layer deposited to a thickness of 1500 nm in the absence of hydrogen. As shown, the sputtered silicon layer deposited in the presence of hydrogen (e.g., sputtered Si:H, a-Si:H, and/or the like) has a significantly higher transmittance level over the wavelength range from approximately 800 nm to approximately 1100 nm relative to the sputtered silicon layer deposited in the absence of hydrogen. Accordingly, using a hydrogenated semiconductor material may generally shift a native bandgap of the semiconductor material to a lower wavelength. For example, as shown in Fig. 2A, standard (unhydrogenated) silicon is not transmissive (or barely transmissive) in the 9xx wavelength regime that includes the wavelength range from approximately 800 nm to approximately 1100 nm, whereas a bandgap of the hydrogenated silicon may be shifted down to about 780-800 nm, giving full transmission capabilities in the 9xx range.

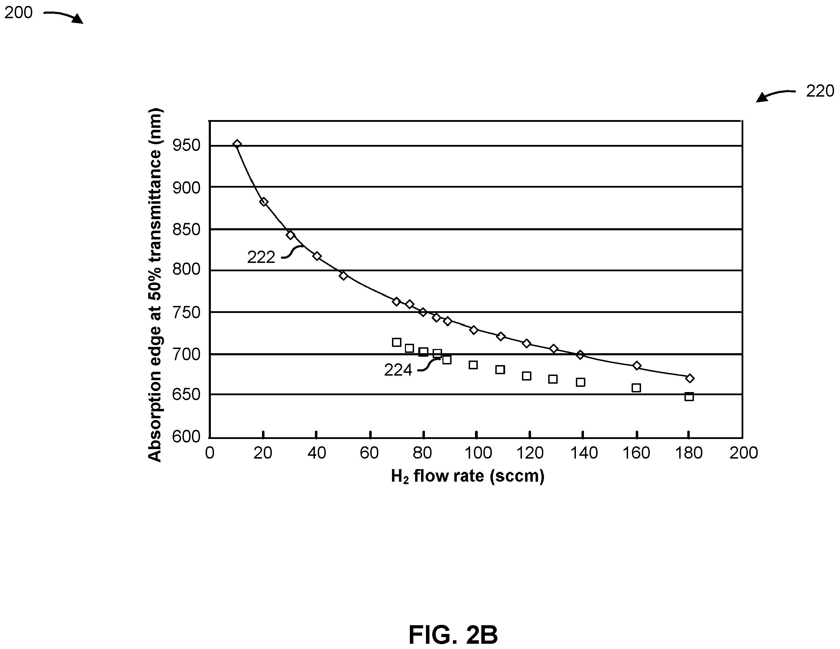

As shown in Fig. 2B, and by chart 220, an annealing process may be used to decrease an absorption-edge wavelength for a hydrogenated silicon layer. For example, in Fig. 2B, reference number 222 shows an absorption-edge wavelength for an Si:H layer at a transmittance level of 50% against a hydrogen flow rate before an annealing step, and reference number 224 shows an absorption-edge wavelength for the Si:H layer after the annealing step. For the asdeposited Si:H layers, the absorption-edge wavelength decreases with increasing hydrogen flow rate and generally varies approximately logarithmically with hydrogen flow rate. The absorption-edge wavelength is decreased further by the annealing step, which may be carried out at a temperature of about 300° Celsius for about 60 minutes. Typically, when an optional post-coating annealing step is performed, the Si:H layer(s) may be annealed at a temperature of up to 350° Celsius for up to 120 minutes, or at a temperature of 250° to 350° Celsius for 30 to 90 minutes. In some implementations, more than one annealing step may be performed.

Accordingly, as shown in Fig. 2B, an absorption-edge wavelength of the sputtered Si:H material can be tuned by adjusting the hydrogen flow rate and/or by annealing. Likewise, the refractive index and the absorption coefficient of the sputtered Si:H material can be tuned by adjusting the hydrogen flow rate and/or by annealing. Typically, the sputtered Si:H layers may be deposited with a hydrogen flow rate of greater than 80 sccm, or with a hydrogen flow rate of about 80 sccm. However, it should be noted that the hydrogen content associated with the flow rate may generally depend on a pumping speed of the vacuum system. Accordingly, whereas single-crystal (monocrystalline) silicon is generally used in silicon photonics applications on operational wavelengths at 1550 nm, the sputtered Si:H material has a low loss and low absorption at shorter wavelengths, including the 9xx wavelength regime. In this way, the sputtered Si:H material may be integrated with readily available and less expensive light sources (e.g., at 940 nm), which is not possible with monocrystalline silicon or Si:H that is deposited at high temperatures via PECVD, due to monocrystalline silicon and Si:H deposited via PECVD having high absorption at shorter wavelengths (e.g., below 1550 nm).

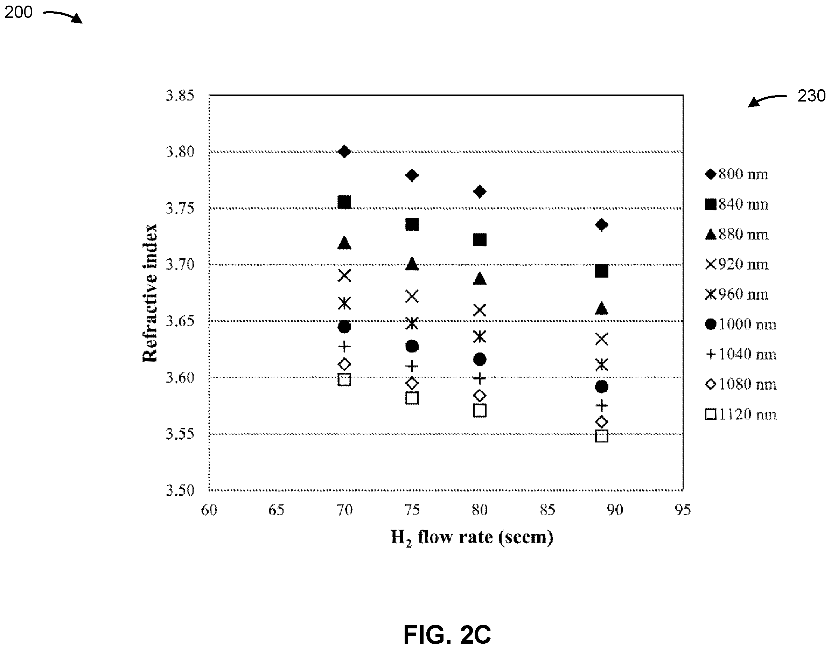

As shown in Fig. 2C, and by chart 230, sputtered Si:H layers may have a refractive index that varies according to hydrogen flow rate. For example, chart 230 shows a plot of refractive indices at wavelengths of 800 nm to 1120 nm relative to hydrogen flow rate for Si:H layers that are deposited via a sputtering process. As shown, the refractive index generally decreases with increasing hydrogen flow rate in an approximately linear manner. In particular, the refractive index of the sputtered Si:H layer produced at a hydrogen flow rate of 80 sccm is greater than 3.55 over the wavelength range of 800 nm to 1120 nm, greater than 3.65 over the wavelength range of 800 nm to 880 nm, and greater than 3.7, greater than 3.75, and about 3.8 at a wavelength of 800 nm. In this way, the hydrogen flow rate may be varied to control or otherwise tune the refractive index of the sputtered Si:H layers.

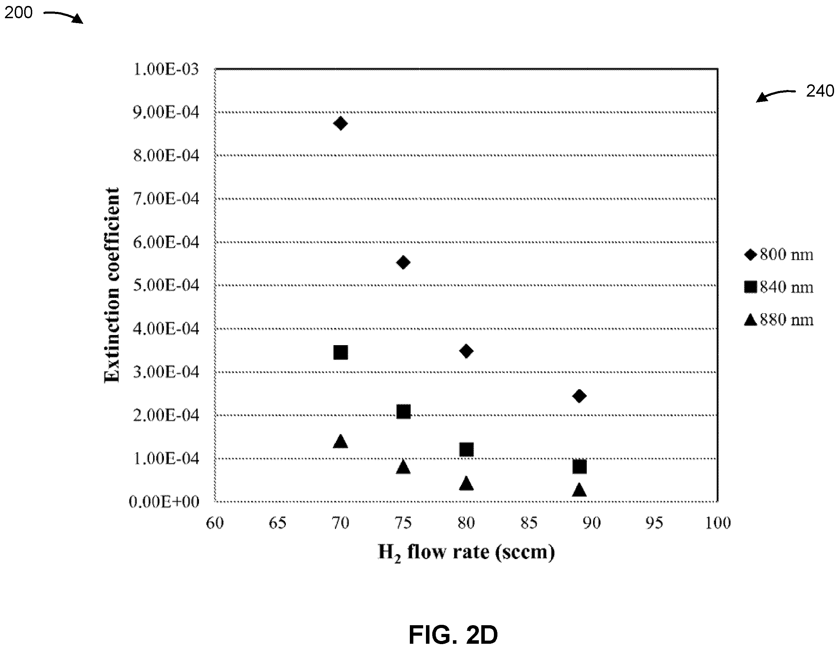

As shown in Fig. 2D, and by chart 240, the sputtered Si:H layers may have an extinction coefficient that varies according to hydrogen flow rate. For example, chart 240 shows a plot of extinction coefficients at wavelengths of 800 nm, 840 nm, and 880 nm against hydrogen flow rate for sputtered Si:H layers (the absorption coefficient is less than 0.0001 at wavelengths of 920 nm to 1120 nm, which are not shown in Fig. 2D). The extinction coefficient (e.g., absorption coefficient) generally decreases with increasing hydrogen flow rate, and the extinction coefficient generally varies approximately exponentially with hydrogen flow rate. In particular, the extinction coefficient of a sputtered Si:H layer produced at a hydrogen flow rate of 80 sccm is less than 0.0004 over the wavelength range of 800 nm to 1120 nm.

Accordingly, the sputtered Si:H layers may be well-suited to applications at lower wavelength ranges that are not demonstrated with monocrystalline silicon or Si:H deposited via PECVD. For example, in a photonics integrated circuit (PIC), a general design objective is to input a certain number of photons into the PIC and maximize photons that are output through some transformation. In the case of an optical filter, the design objective may be to pass substantial light to a detector at one particular wavelength and reject light at another wavelength. As a result, relative to a PIC fabricated with monocrystalline silicon or Si:H deposited via PECVD, a PIC fabricated with one or more sputtered Si:H layers may have a high transmissivity, a low absorption, a high refractive index, and/or other optical properties to enable a low-angle shift of a bandpass in the 9xx wavelength regime. For example, a PIC fabricated with monocrystalline silicon or Si:H deposited via PECVD may have a higher absorption coefficient relative to the sputtered Si:H, which means that fewer photons may be output from a PIC fabricated with monocrystalline silicon or Si:H deposited via PECVD, because absorption is higher. In contrast, because the sputtered Si:H has a higher transmissivity, lower absorption, and/or the like, a PIC fabricated with one or more sputtered Si:H layers may output a higher proportion of the photons that are input to the PIC, resulting in a higher-quality output signal.

As indicated above, Figs. 2A-2D are provided merely as one or more examples. Other examples may differ from what is described with regard to Figs. 2A-2D.

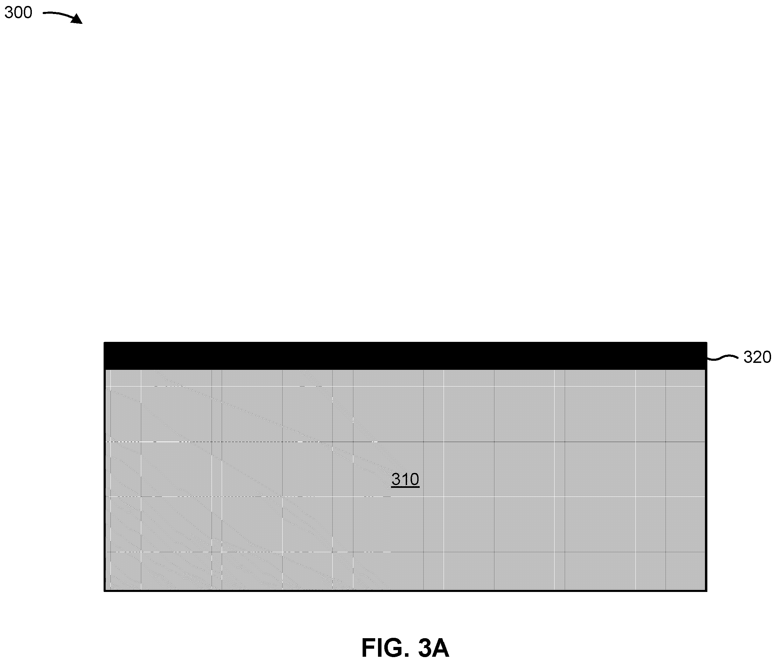

Figs. 3A-3D are diagrams of one or more example implementations 300 described herein. In particular, Figs. 3A-3D illustrate example stackups of one or more PICs that include one or more layers that are formed from a hydrogenated semiconductor material and deposited using a sputter deposition system.

As shown in Fig. 3A, one example PIC may include a substrate 310 with a layer 320 of a hydrogenated semiconductor material deposited on the substrate 310. In some implementations, the substrate 310 may be a glass substrate, a silica substrate, and/or the like, and the layer 320 may include a layer of hydrogenated silicon (Si:H), amorphous Si:H (a-Si:H), and/or the like that is deposited on the substrate 310 via a sputtering process until a thickness of the layer 320 satisfies a threshold (e.g., until the layer 320 has a desired thickness). For example, in some implementations, the sputtering process may be a reactive magnetron sputtering process, as described in further detail elsewhere herein. Furthermore, in some implementations, the sputtering process may be performed at a temperature that is at a suitable level to avoid causing damage to the substrate 310 and/or the layer 320 of the sputtered semiconductor material, such as a temperature in a range from 145° Celsius to 165° Celsius, from 150° Celsius to 160° Celsius, and/or the like, which may enable additional layers of planar circuitry to be formed on the layer 320. As described herein, the structure shown in Fig. 3A may be a substrate wafer that can be subjected to further fabrication steps to manufacture a PIC, such as a silicon photonics device.

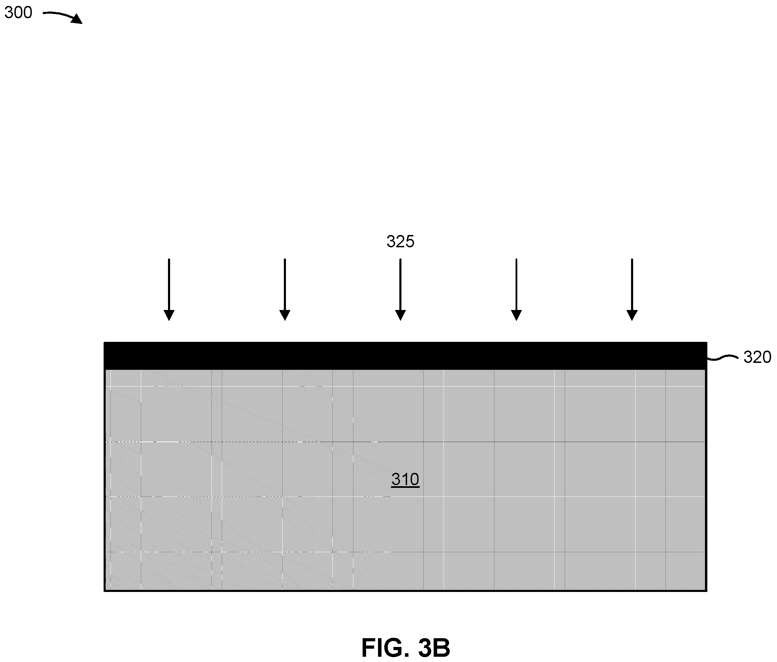

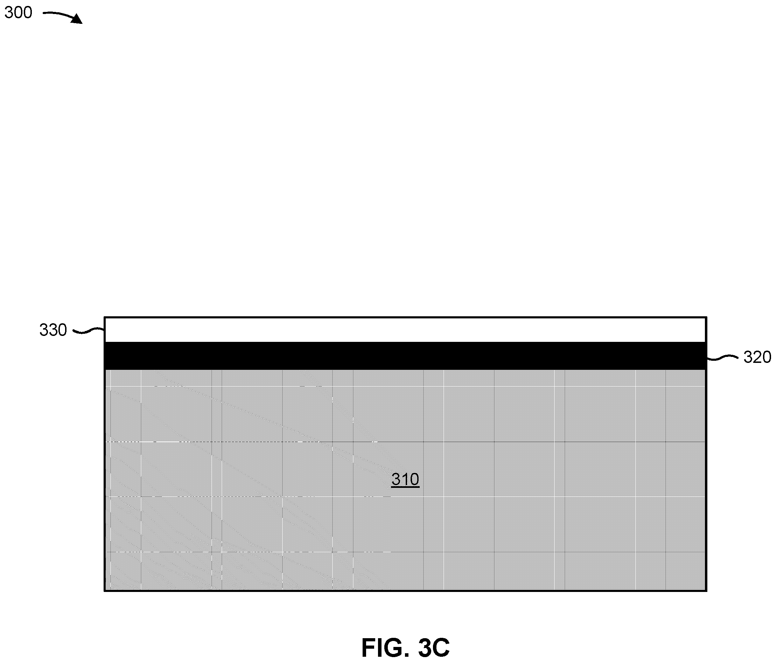

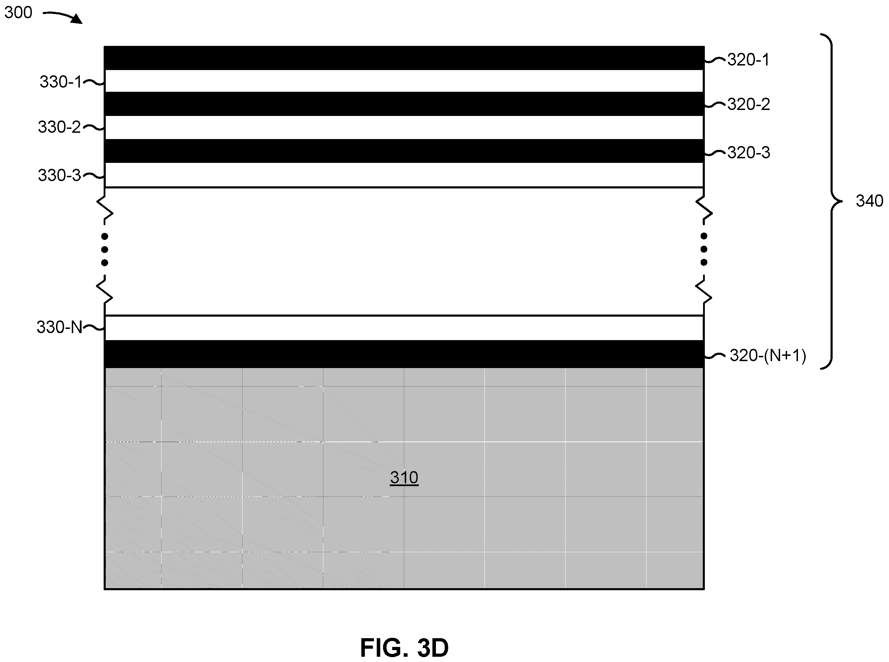

For example, as shown in Fig. 3B, and by reference number 325, an etching process may be performed to etch a structure into the layer 320 of the sputtered semiconductor material. For example, in some implementations, the etching process may be a reactive ion etching process or another suitable etching process. In some implementations, etching the structure into the layer 320 of the sputtered semiconductor material may result in a PIC corresponding to a base waveguide structure with an air cladding. Additionally, or alternatively, as shown in Fig. 3C, an additional layer 330 formed from a dielectric material such as silicon dioxide (SiO₂) may be deposited on the layer 320 of the sputtered semiconductor material (e.g., post-etching) to create an additional confinement layer for the waveguide structure. Additionally, or alternatively, as shown in Fig. 3D, layers 320 (320-1 to 320-N) of the sputtered semiconductor material may be deposited in alternation with layers 330 (330-1 to 330-N) formed from a different material that has a different refractive index than the sputtered semiconductor material to form an optical filter structure.

In some implementations, as described herein, using a sputtering process to fabricate a PIC with one or more layers formed from a hydrogenated semiconductor material, such as Si:H, a-Si:H, and/or the like, may shift a band edge of absorption to a low level that is sufficient to enable operation at short wavelengths, such as wavelengths in a 9xx nanometer wavelength regime. One factor that enables such operation is the mechanics in how hydrogen combines with the semiconductor material (e.g., silicon) during sputtering, which may result in a purer material than can be realized in deposition of a hydrogenated semiconductor material via PECVD (e.g., the sputtered film has less contaminants and/or defects). Furthermore, the sputtering process can produce a denser film that provides a better microstructure that effectively translates to better optical properties. Furthermore, sputtering enables substantial control over a deposition rate, which can enable operation in the 9xx wavelength regime due to properties of the hydrogenated semiconductor material (e.g., as described above with respect to Figs. 2A-2D) and the sputtering process that enables uniformity of layer control and homogeneity of the sputtered semiconductor material. For example, PECVD used in a typical semiconductor foundry context offers precision in layer control in a range from +/- 5-10%, whereas sputtering enables precision at +/- 1%, which is an order of magnitude better, that may enable high-end optical applications. Furthermore, the sputtering process may enable substantial control over tuning optical properties of the hydrogenated semiconductor material (e.g., by varying a hydrogen flow rate, a sputtering gas flow rate, a PAS power level, a cathode power level, a deposition rate, a temperature, a pressure, and/or the like), which may enable high-yielding, planar circuitry for use in silicon photonics.

As indicated above, Figs. 3A-3D are provided merely as one or more examples. Other examples may differ from what is described with regard to Figs. 3A-3D.

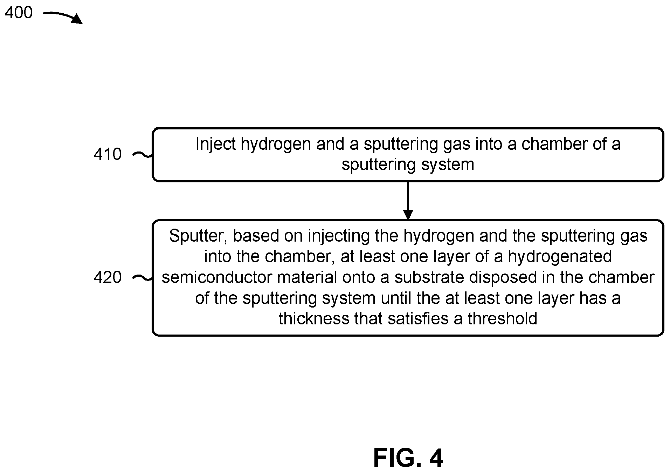

Fig. 4 is a flow chart of an example process 400 for fabricating a photonic integrated circuit (PIC) with a sputtered semiconductor material. In some implementations, one or more process blocks of Fig. 4 may be performed by a sputter deposition system (e.g., sputter deposition system 100). In some implementations, one or more process blocks of Fig. 4 may be performed by another device or a group of devices separate from or including the sputter deposition system 100, such as etching machinery and/or the like.

As shown in Fig. 4, process 400 may include injecting hydrogen and a sputtering gas into a chamber of a sputtering system (block 410). For example, the sputter deposition system (e.g., using plasma activation source (PAS) 160, PAS power supply 170, and/or the like) may inject hydrogen and a sputtering gas into a chamber 110 of the sputtering system, as described above.

As further shown in Fig. 4, process 400 may include sputtering, based on injecting the hydrogen and the sputtering gas into the chamber, at least one layer of a hydrogenated semiconductor material onto a substrate disposed in the chamber of the sputtering system until the at least one layer has a thickness that satisfies a threshold (block 420). For example, the sputter deposition system (e.g., using cathode 130, cathode power supply 140, anode 150, PAS 160, PAS power supply 170, and/or the like) may sputter, based on injecting the hydrogen and the sputtering gas into the chamber 110, at least one layer of a hydrogenated semiconductor material onto a substrate 120 disposed in the chamber 110 of the sputtering system until the at least one layer has a thickness that satisfies a threshold, as described above.

Process 400 may include additional implementations, such as any single implementation or any combination of implementations described below and/or in connection with one or more other processes described elsewhere herein.

In a first implementation, the at least one layer of the hydrogenated semiconductor material includes an amorphous hydrogenated silicon (a-Si:H) material.

In a second implementation, alone or in combination with the first implementation, the at least one layer of the hydrogenated semiconductor material is sputtered onto the substrate while a temperature in the chamber of the sputtering system is in a range from 145 degrees Celsius to 165 degrees Celsius.

In a third implementation, alone or in combination with one or more of the first and second implementations, the at least one layer of the hydrogenated semiconductor material is sputtered onto the substrate using reactive magnetron sputtering.

In a fourth implementation, alone or in combination with one or more of the first through third implementations, process 400 includes etching a surface of the at least one layer of the hydrogenated semiconductor material using reactive ion etching to form a waveguide structure.

In a fifth implementation, alone or in combination with one or more of the first through fourth implementations, process 400 includes depositing, on the etched surface of the at least one layer of the hydrogenated semiconductor material, an additional material layer to form a confinement layer for the waveguide structure.

In a sixth implementation, alone or in combination with one or more of the first through fifth implementations, the at least one sputtered layer of the hydrogenated semiconductor material has a first refractive index, and process 400 further includes depositing, on the at least one sputtered layer of the hydrogenated semiconductor material, an additional layer of a material having a second refractive index that is less than the first refractive index, to form an optical filter structure.

In a seventh implementation, alone or in combination with one or more of the first through sixth implementations, the at least one sputtered layer of the hydrogenated semiconductor material has one or more optical properties that satisfy a threshold at wavelengths in a range from 800 nanometers to 1100 nanometers.

In an eighth implementation, alone or in combination with one or more of the first through seventh implementations, the one or more optical properties of the at least one sputtered layer of the hydrogenated semiconductor material satisfy the threshold at wavelengths larger than 1100 nanometers.

In a ninth implementation, alone or in combination with one or more of the first through eighth implementations, the one or more optical properties include at least one of a transmissivity, an absorption, or a refractive index.

Although Fig. 4 shows example blocks of process 400, in some implementations, process 400 may include additional blocks, fewer blocks, different blocks, or differently arranged blocks than those depicted in Fig. 4. Additionally, or alternatively, two or more of the blocks of process 400 may be performed in parallel.

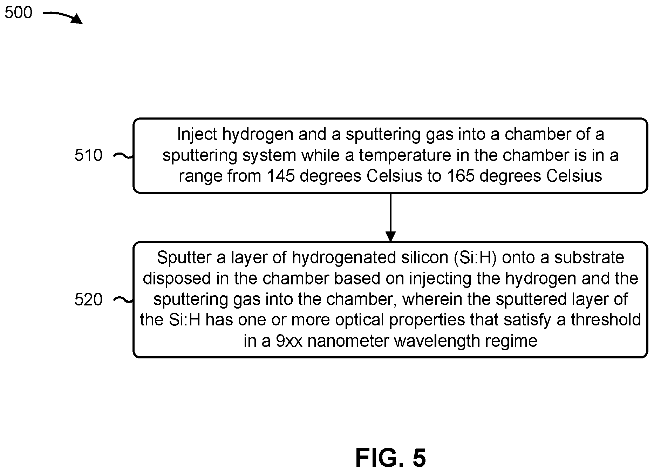

Fig. 5 is a flow chart of an example process 500 for fabricating a PIC with a sputtered semiconductor material. In some implementations, one or more process blocks of Fig. 5 may be performed by a sputter deposition system (e.g., sputter deposition system 100). In some implementations, one or more process blocks of Fig. 4 may be performed by another device or a group of devices separate from or including the sputter deposition system 100, such as etching machinery and/or the like.

As shown in Fig. 5, process 500 may include injecting hydrogen and a sputtering gas into a chamber of a sputtering system while a temperature in the chamber is in a range from 145 degrees Celsius to 165 degrees Celsius (block 510). For example, the sputter deposition system (e.g., using PAS 160, PAS power supply 170, and/or the like) may inject hydrogen and a sputtering gas into a chamber of a sputtering system while a temperature in the chamber is in a range from 145 degrees Celsius to 165 degrees Celsius, as described above.

As further shown in Fig. 5, process 500 may include sputtering a layer of hydrogenated silicon (Si:H) onto a substrate disposed in the chamber based on injecting the hydrogen and the sputtering gas into the chamber, wherein the sputtered layer of the Si:H has one or more optical properties that satisfy a threshold in a 9xx nanometer wavelength regime (block 520). For example, the sputter deposition system (e.g., using cathode 130, cathode power supply 140, anode 150, PAS 160, PAS power supply 170, and/or the like) may sputter a layer of Si:H onto a substrate disposed in the chamber based on injecting the hydrogen and the sputtering gas into the chamber, as described above. In some implementations, the sputtered layer of the Si:H has one or more optical properties that satisfy a threshold in a 9xx nanometer wavelength regime.

Process 500 may include additional implementations, such as any single implementation or any combination of implementations described below and/or in connection with one or more other processes described elsewhere herein.

In a first implementation, the 9xx nanometer wavelength regime includes wavelengths in a range from 800 nanometers to 1100 nanometers.

In a second implementation, alone or in combination with the first implementation, the layer of the Si:H is sputtered onto the substrate until a thickness of the sputtered layer of the Si:H satisfies a threshold.

In a third implementation, alone or in combination with one or more of the first and second implementations, the one or more optical properties of the sputtered layer of the Si:H satisfy the threshold in a 1550 nanometer wavelength regime.

In a fourth implementation, alone or in combination with one or more of the first through third implementations, the layer of the Si:H is sputtered onto the substrate using reactive magnetron sputtering.

In a fifth implementation, alone or in combination with one or more of the first through fourth implementations, the sputtered layer of the Si:H has one or more of a higher transmissivity, a lower absorption, or a higher refractive index in the 9xx nanometer wavelength regime relative to monocrystalline silicon.

In a sixth implementation, alone or in combination with one or more of the first through fifth implementations, the sputtered layer of the Si:H has one or more of a higher transmissivity, a lower absorption, or a higher refractive index in the 9xx nanometer wavelength regime relative to Si:H deposited by plasma enhanced chemical vapor deposition.

Although Fig. 5 shows example blocks of process 500, in some implementations, process 500 may include additional blocks, fewer blocks, different blocks, or differently arranged blocks than those depicted in Fig. 5. Additionally, or alternatively, two or more of the blocks of process 500 may be performed in parallel.

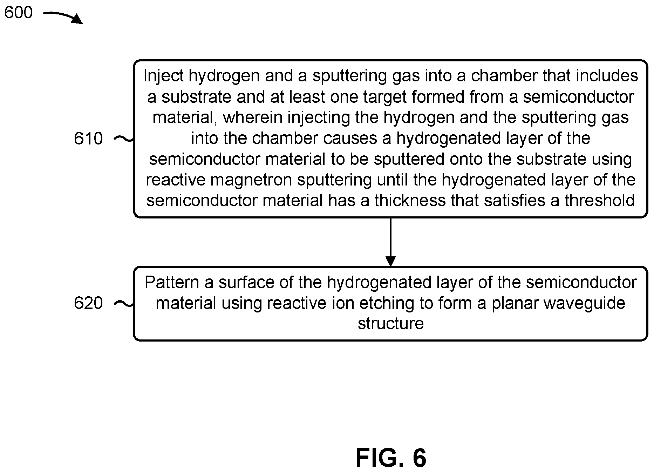

Fig. 6 is a flow chart of an example process 600 for fabricating a PIC with a sputtered semiconductor material. In some implementations, one or more process blocks of Fig. 6 may be performed by a sputter deposition system (e.g., sputter deposition system 100). In some implementations, one or more process blocks of Fig. 4 may be performed by another device or a group of devices separate from or including the sputter deposition system 100, such as etching machinery and/or the like.

As shown in Fig. 6, process 600 may include injecting hydrogen and a sputtering gas into a chamber that includes a substrate and at least one target formed from a semiconductor material, wherein injecting the hydrogen and the sputtering gas into the chamber causes a hydrogenated layer of the semiconductor material to be sputtered onto the substrate using reactive magnetron sputtering until the hydrogenated layer of the semiconductor material has a thickness that satisfies a threshold (block 610). For example, the sputter deposition system (e.g., using cathode 130, cathode power supply 140, anode 150, PAS 160, PAS power supply 170, and/or the like) may inject hydrogen and a sputtering gas into a chamber that includes a substrate and at least one target formed from a semiconductor material, as described above. In some implementations, injecting the hydrogen and the sputtering gas into the chamber causes a hydrogenated layer of the semiconductor material to be sputtered onto the substrate using reactive magnetron sputtering until the hydrogenated layer of the semiconductor material has a thickness that satisfies a threshold.

As further shown in Fig. 6, process 600 may include patterning a surface of the hydrogenated layer of the semiconductor material using reactive ion etching to form a planar waveguide structure (block 620). For example, the etching machinery may pattern a surface of the hydrogenated layer of the semiconductor material using reactive ion etching to form a planar waveguide structure, as described above.

Process 600 may include additional implementations, such as any single implementation or any combination of implementations described below and/or in connection with one or more other processes described elsewhere herein.

In a first implementation, the planar waveguide structure has an air cladding.

In a second implementation, alone or in combination with the first implementation, process 600 includes depositing, on the etched surface of the hydrogenated layer of the semiconductor material, an additional layer to form a confinement layer for the planar waveguide structure.

Although Fig. 6 shows example blocks of process 600, in some implementations, process 600 may include additional blocks, fewer blocks, different blocks, or differently arranged blocks than those depicted in Fig. 6. Additionally, or alternatively, two or more of the blocks of process 600 may be performed in parallel.

The foregoing disclosure provides illustration and description, but is not intended to be exhaustive or to limit the implementations to the precise form disclosed. Modifications and variations are possible in light of the above disclosure or may be acquired from practice of the implementations.

As used herein, satisfying a threshold may, depending on the context, refer to a value being greater than the threshold, more than the threshold, higher than the threshold, greater than or equal to the threshold, less than the threshold, fewer than the threshold, lower than the threshold, less than or equal to the threshold, equal to the threshold, and/or the like.

Even though particular combinations of features are recited in the claims and/or disclosed in the specification, these combinations are not intended to limit the disclosure of various implementations. In fact, many of these features may be combined in ways not specifically recited in the claims and/or disclosed in the specification. Although each dependent claim listed below may directly depend on only one claim, the disclosure of various implementations includes each dependent claim in combination with every other claim in the claim set.

No element, act, or instruction used herein should be construed as critical or essential unless explicitly described as such. Also, as used herein, the articles "a" and "an" are intended to include one or more items, and may be used interchangeably with "one or more." Further, as used herein, the article "the" is intended to include one or more items referenced in connection with the article "the" and may be used interchangeably with "the one or more." Furthermore, as used herein, the term "set" is intended to include one or more items (e.g., related items, unrelated items, a combination of related and unrelated items, etc.), and may be used interchangeably with "one or more." Where only one item is intended, the phrase "only one" or similar language is used. Also, as used herein, the terms "has," "have," "having," or the like are intended to be open-ended terms. Further, the phrase "based on" is intended to mean "based, at least in part, on" unless explicitly stated otherwise. Also, as used herein, the term "or" is intended to be inclusive when used in a series and may be used interchangeably with "and/or," unless explicitly stated otherwise (e.g., if used in combination with "either" or "only one of').

## Claims

1. A method for fabricating a photonic integrated circuit, comprising:
injecting hydrogen and a sputtering gas into a chamber of a sputtering system; and
sputtering, based on injecting the hydrogen and the sputtering gas into the chamber, at least one layer of a hydrogenated semiconductor material onto a substrate disposed in the chamber of the sputtering system until the at least one layer has a thickness that satisfies a threshold.

2. The method of claim 1, wherein the at least one layer of the hydrogenated semiconductor material includes an amorphous hydrogenated silicon (a-Si:H) material and/or is sputtered onto the substrate while a temperature in the chamber of the sputtering system is in a range from 145 degrees Celsius to 165 degrees Celsius.

3. The method of claim 1, wherein the at least one layer of the hydrogenated semiconductor material is sputtered onto the substrate using reactive magnetron sputtering.

4. The method of claim 1, further comprising:
etching a surface of the at least one layer of the hydrogenated semiconductor material using reactive ion etching to form a waveguide structure, and, optionally,
depositing, on the etched surface of the at least one layer of the hydrogenated semiconductor material, an additional material layer to form a confinement layer for the waveguide structure.

5. The method of claim 1, wherein:
the at least one sputtered layer of the hydrogenated semiconductor material has a first refractive index, and
the method further comprises:
depositing, on the at least one sputtered layer of the hydrogenated semiconductor material, an additional layer of a material having a second refractive index that is less than the first refractive index, to form an optical filter structure.

6. The method of claim 1, wherein the at least one sputtered layer of the hydrogenated semiconductor material has one or more optical properties that satisfy a threshold at wavelengths in a range from 800 nanometers to 1100 nanometers and, optionally, wherein the one or more optical properties include at least one of a transmissivity, an absorption, or a refractive index.

7. The method of claim 6, wherein the one or more optical properties of the at least one sputtered layer of the hydrogenated semiconductor material satisfy the threshold at wavelengths larger than 1100 nanometers.

8. A method for fabricating a photonic integrated circuit, comprising:
injecting hydrogen and a sputtering gas into a chamber of a sputtering system while a temperature in the chamber is in a range from 145 degrees Celsius to 165 degrees Celsius; and
sputtering a layer of hydrogenated silicon (Si:H) onto a substrate disposed in the chamber based on injecting the hydrogen and the sputtering gas into the chamber,
wherein the sputtered layer of the Si:H has one or more optical properties that satisfy a threshold in a 9xx nanometer wavelength regime.

9. The method of claim 8, wherein the 9xx nanometer wavelength regime includes wavelengths in a range from 800 nanometers to 1100 nanometers.

10. The method of claim 8, wherein the layer of the Si:H is sputtered onto the substrate until a thickness of the sputtered layer of the Si:H satisfies a threshold and/or using reactive magnetron sputtering.

11. The method of claim 8, wherein the one or more optical properties of the sputtered layer of the Si:H satisfy the threshold in a 1550 nanometer wavelength regime.

12. The method of claim 8, wherein the sputtered layer of the Si:H has one or more of a higher transmissivity, a lower absorption, or a higher refractive index in the 9xx nanometer wavelength regime relative to monocrystalline silicon or Si:H deposited by plasma enhanced chemical vapor deposition.

13. A method for fabricating a photonic integrated circuit, comprising:
injecting, by a sputtering system, hydrogen and a sputtering gas into a chamber that includes a substrate and at least one target formed from a semiconductor material,
wherein injecting the hydrogen and the sputtering gas into the chamber causes a hydrogenated layer of the semiconductor material to be sputtered onto the substrate using reactive magnetron sputtering until the hydrogenated layer of the semiconductor material has a thickness that satisfies a threshold; and
patterning a surface of the hydrogenated layer of the semiconductor material using reactive ion etching to form a planar waveguide structure.

14. The method of claim 13, wherein the planar waveguide structure has an air cladding.

15. The method of claim 13, further comprising:
depositing, on the etched surface of the hydrogenated layer of the semiconductor material, an additional layer to form a confinement layer for the planar waveguide structure.
